# EUROPEAN PATENT SPECIFICATION

(11) **EP 0 841 703 B1**
(45) Date of publication and mention of the grant of the patent: **17.11.2004**
(21) Application number: 97307559.1
(22) Date of filing: 26.09.1997
(51) Int. Cl.: H01L 29/12, H01L 21/26, C23C 14/04, B22F 1/00

(54) **Ultrafine particle structure and production method thereof**
Ultrafeine Teilchenstruktur und Verfahren zu ihrer Herstellung
Structure particulaire ultrafine et procédé de sa préparation

(30) Priority: 26.09.1996 JP 25415096
(43) Date of publication of application: 13.05.1998
(73) Proprietor: Japan Science and Technology Corporation, Kawaguchi-shi, Saitama (JP); KABUSHIKI KAISHA TOSHIBA, Kawasaki-shi, Kanagawa-ken 210-8572 (JP)
(72) Inventor: Tanaka, Shun-ichiro, Yokohama-shi, Kanagawa-ken (JP); Xu, BingShe, Yokohama-shi, Kanagawa-ken (JP)
(74) Representative: Waldren, Robin Michael

(56) References cited:
- EP-A- 0 726 228
- EP-A- 0 808 682
- SCHLEICHER B ET AL: "CHARACTERIZATION OF NANOSTRUCTURED CARBON MICROWIRES FABRICATED BY AN AEROSOL PROCESS" JOURNAL OF APPLIED PHYSICS,AMERICAN INSTITUTE OF PHYSICS. NEW YORK,US, vol. 78, no. 10, 15 November 1995 (1995-11-15), pages 6046-6049, XP000541631 ISSN: 0021-8979
- GOTSCHY W ET AL : "Optical dichromism of lithographically designed silver nanoparticle films" OPTICS LETTERS, vol. 21, no. 15, 1 August 1996 (1996-08-01), pages 1099-1101, XP000974267 Opt. Soc. America, USA

## Description

The present invention relates to ultrafine particle bonded bodies utilizing ultrafine particles formed of metal, semiconductor and the like, and a method for producing the ultrafine particle bonded bodies.

When metal particles and compound particles such as metal oxide particles and the like are made ultrafine in particle diameter, for example, less than 100 nm, there appear properties different from those of ordinary particles (for example, 1 µm or larger). In an ultrafine particle, a number of atoms existing on surface areas increase relative to a total number of atoms. Therefore, since an influence of surface energy on properties of the particle can not be ignored, new properties may be produced.

The ultrafine particles are suitable for discovering a new surface phenomenon or understanding an outline of the new surface phenomenon. There occur, in the ultrafine particle, lowering of melting point and sintering temperature. They are different from the properties of a bulk. Further, when a plurality of ultrafine particles are present, a tunnel effect may be caused among them, or a quantum mechanical effects (such as a quantum well and a mini-band) may take place. Depending on the types of the ultrafine particles, a high catalytic effect can be obtained. These ultrafine particles can be used to improve the properties of materials and to develop a very fine device, and can also be applied to functional materials such as a catalyst. Physical properties of the ultrafine particles and a usage of ultrafine particles have been forwarded.

Conventional ultrafine particles are produced according to such physical methods and chemical methods as described below. Concerning physical methods for producing ultrafine particles, a gas evaporation method, a metal evaporation synthesis method, and a vacuum evaporation method on a fluid oil can be cited. In the gas evaporation method, ultrafine particles are formed by evaporating a metal or the like in an inert gas atmosphere, and, thereafter, by cooling and condensing through collision of the evaporated metal with the gas. To obtain a material for the ultrafine particles, a sputtering method can be used. In the metal evaporation synthesis method, ultrafine particles are obtained, after heating a metal in a vacuum, by depositing evaporated metal atoms together with an organic solvent on a substrate cooled below a freezing point of the organic solvent. In the vacuum evaporation method on a fluid oil, ultrafine particles are obtained by evaporating a metal on oil.

As the chemical methods for producing ultrafine particles, the methods utilizing a liquid phase or a gaseous phase are known. In the methods using a liquid phase, a colloid method, an alkoxide method, coprecipitating method and the like can be cited. The colloid method reduces precious metal salt in an alcohol coexisted with a high polymer surfactant under a reflux condition. The alkoxide method is a method using hydrolysis of a metal alkoxide. The coprecipitating method is a method to obtain precipitate particles by adding a precipitant to a mixed solution of a metal salt.

As the production methods using a gas phase, a thermal decomposition method of organometallic compounds, a reaction method of metal chlorides, a reduction method in hydrogen, and a solvent evaporation method can be cited. In the thermal decomposition method of organometallic compounds, ultrafine particles of a metal are obtained by decomposing thermally a metal carbonyl compound or the like. In the reaction method of metal chlorides, ultrafine particles are obtained by reducing/oxidizing/nitriding a metal chloride in a reaction gas flow. In the reduction method in hydrogen, an oxide or a hydrate is reduced by heating in a hydrogen current to obtain ultrafine particles. In the solvent evaporation method, a solution of a metal chloride is atomized through a nozzle and dried by hot air to obtain ultrafine particles.

Incidentally, conventional research and development of ultrafine particles are mainly related to an aggregate of ultrafine particles. The properties and applications of ultrafine particles and also various ways of operating the ultrafine particles as a unit substance are less studied. This results also from the conventional production method of the ultrafine particles. It was difficult to obtain the ultrafine particle as a unit substance in the conventional production methods.

Some studies are being made to apply the ultrafine particles to devices and various functional materials. However, in the conventional production method, even if the ultrafine particle is obtained as a unit substance, its position and formed state can not be fully controlled. Consequently, ultrafine particle bonded bodies such as ultrafine wirings, ultrafine devices, and ultrafine functional materials which utilizes ultrafine particles are impossible to obtain. This prevents to expand application areas of the ultrafine particles.

From the above mentioned reasons, technology which facilitates, by controlling position and state of ultrafine particles to be formed, to form various shapes of ultrafine particle bonded bodies are demanded. In particular, technology which facilitates to form ultrafine particle bonded bodies while maintaining properties of the ultrafine particles are strongly demanded.

EP 0 726 228 is a prior art document which relates to producing ultrafine particle-enclosing fullerene.

EP 0·808 682 is a prior art document only in relation to novelty and only for Germany, France and Great Britain. The disclosure of this document relates to producing ultrafine particle bonded bodies.

An object of the present invention is, through realization of techniques for controlling positions and states of ultrafine particles of various materials to be formed, to facilitate to obtain ultrafine particle bonded bodies, which utilize ultrafine particles, such as ultrafine wirings, ultrafine devices, and ultrafine functional materials. In particular, an object of the present invention is to provide a method for producing ultrafine particle bonded bodies which preserve properties of ultrafine particles.

According to one aspect, the present invention provides an ultrafine particle structure comprising a substrate having a main surface and a plurality of ultrafine particles disposed continuously on the main surface of the substrate,
wherein the ultrafine particles are composed of constituent atoms or molecules detached from a target material, which has a slit and is disposed on the substrate, by irradiating a high energy beam in a slanting direction, and exist at a position corresponding to the slit.

Preferably, the ultrafine particles have particle diameters in the range of from 2 to 200 nm respectively. It is also preferable that the ultrafine particles are at least partly bonded between adjacent ultrafine particles.

Preferably, the ultrafine particles are bonded between adjacent ultrafine particles by irradiation of an electron beam.

The ultrafine particle structure of the present invention can comprise at least one selected from metal ultrafine particles, semiconductor ultrafine particles, and compound ultrafine particles. Ultrafine particle used as a building unit of ultrafine particle structure can be a plurality of types of ultrafine particles composed of different materials.

According to another aspect, the present invention provides a method for producing an ultrafine particle structure, comprising:
disposing a target material having a slit of desired shape on a substrate;
irradiating a high energy beam collectively in a slanting direction on an inner wall surface of the slit of the target material to detach constituent atoms or molecules of the target material; and
forming a plurality of ultrafine particles by adhering the constituent atoms or molecules detached from the target material on the substrate, wherein the ultrafine particles are disposed on the substrate along the shape of the slit.

According to a further aspect, the present invention provides a method for producing an ultrafine particle structure, comprising:
disposing a target material having a slit of desired shape on a substrate;
irradiating a high energy beam continuously or intermittently in a slanting direction on an inner wall surface of the slit of the target material along the shape of the slit to detach constituent atoms or molecules of the target material; and
forming a plurality of ultrafine particles by adhering the constituent atoms or molecules detached from the target material on the substrate, wherein the ultrafine particles are disposed continuously on the substrate along the shape of the slit.

A method for producing the ultrafine particle structure of the present invention may further possess a step for bonding between adjacent ultrafine particles by irradiating an electron beam on a plurality of continuously disposed ultrafine particles.

In a production method for producing the ultrafine particle structure of the present invention, a plurality of target materials different in at least one of slit shape or material from the other can be used. An irradiation of a high energy beam in a slanting direction is executed on each of a plurality of the target materials, respectively.

After disposition of a target material having a slit on a substrate, by irradiating a high energy beam in a slanting direction on an inside wall of the slit of the target material, constituent atoms or molecules of the target material are liberated. Constituent atoms or molecules thus liberated from the target material are continuously disposed on a substrate according to a shape of the slit. Thus, an ultrafine particle structure composed of a plurality of continuously disposed ultrafine particles, which are composed of the constituent atoms or molecules of the target material, can be obtained. The ultrafine particle structure has a shape corresponding to the shape of the slit.

In the ultrafine particle structure of the present invention, the minimum width and the like can be basically designed according to a shape of ultrafine particle. Further, a shape of an ultrafine particle structure can be corresponded to a shape of a slit. Component materials of ultrafine particle is determined according to types of target material, further an atmosphere during irradiation of a high energy beam, and the like. Therefore, by using various types of ultrafine particles such as a metal ultrafine particle, a semiconductor ultrafine particle, a compound ultrafine particle, and the like, various types of ultrafine wirings, ultrafine devices, and ultrafine functional materials having required shape and formed with nanometer order precision can be produced. Even if a plurality of types of ultrafine particles are different in substances, similar ultrafine wirings, ultrafine devices, and ultrafine functional materials can be produced.

By irradiating further an electron beam on a plurality of ultrafine particles obtained by irradiating a high energy beam in a slanting direction on an inner wall of a slit of a target material, the ultrafine particles can be bonded between adjacent ultrafine particles. Thereby, reliability of ultrafine particle bonded array formed of a plurality of continuously disposed ultrafine particles can be improved.
Fig. 1A is a sectional view showing a disposition state of a target material in a process for producing an ultrafine particle structure according to one embodiment of the present invention.
Fig. 1B is a sectional view showing an initial stage for forming a plurality of ultrafine particles in a production process according to one embodiment of an ultrafine particle structure of the present invention.
Fig. 1C is a sectional view showing an ultrafine particle structure produced according to a production process of one embodiment of an ultrafine particle structure of the present invention.
Fig. 1D shows a state in which an electron beam is being further irradiated on an ultrafine particle structure produced according to a production process of one embodiment of an ultrafine particle structure of the present invention.
Fig. 2 is a perspective view showing an example of a shape of a target material and a slit used when producing an ultrafine particle structure of the present invention.
Fig. 3 is a perspective view showing the other example of a shape of a target material and a slit used when producing an ultrafine particle structure of the present invention.
Fig. 4 is a perspective view showing as a partial sectional view an irradiation step of a high energy beam in one production process of an ultrafine particle structure of the present invention.
Fig. 5A is a perspective view showing schematically a disposed state of a first target material in a production process of the other embodiment of an ultrafine particle structure of the present invention.
Fig. 5B is a perspective view showing schematically a disposed state of a second target material in a production process of the other embodiment of an ultrafine particle structure of the present invention.
Fig. 5C is a perspective view showing an ultrafine particle structure produced according to the other embodiment of an ultrafine particle structure of the present invention.

Embodiments for implementing the present invention will be described.

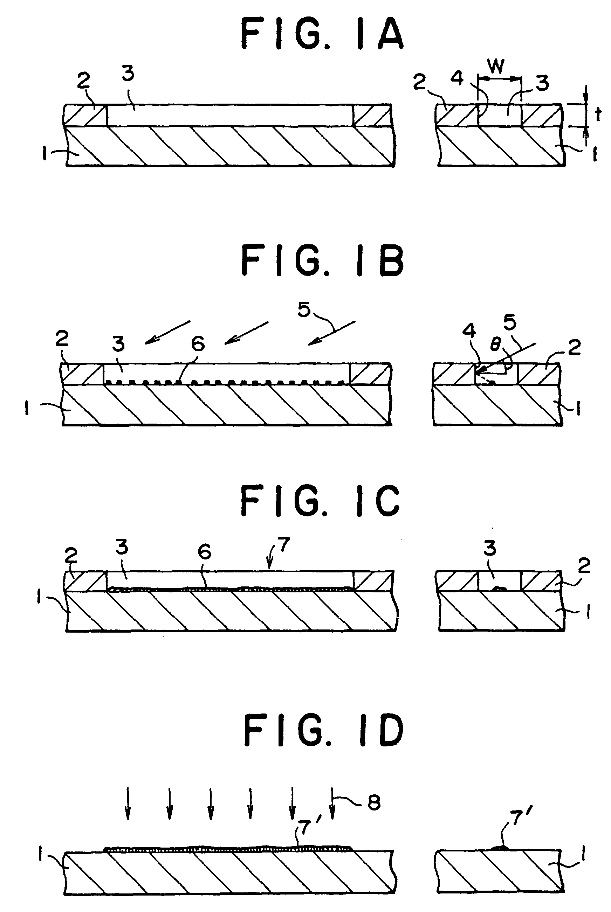

Fig. 1A to Fig. 1C are sectional views showing schematically one embodiment of a production process of an ultrafine particle structure of the present invention. In the figures, reference numeral 1 designates a substrate for producing an ultrafine particle structure. Various types of solid materials can be used for the substrate 1. In concrete, the substrate 1 can be formed of any type of solid materials regardless whether it is a crystalline substrate or an amorphous substrate. For the substrate 1, metal, non-metal, semiconductor, compound and other substrates can be used.

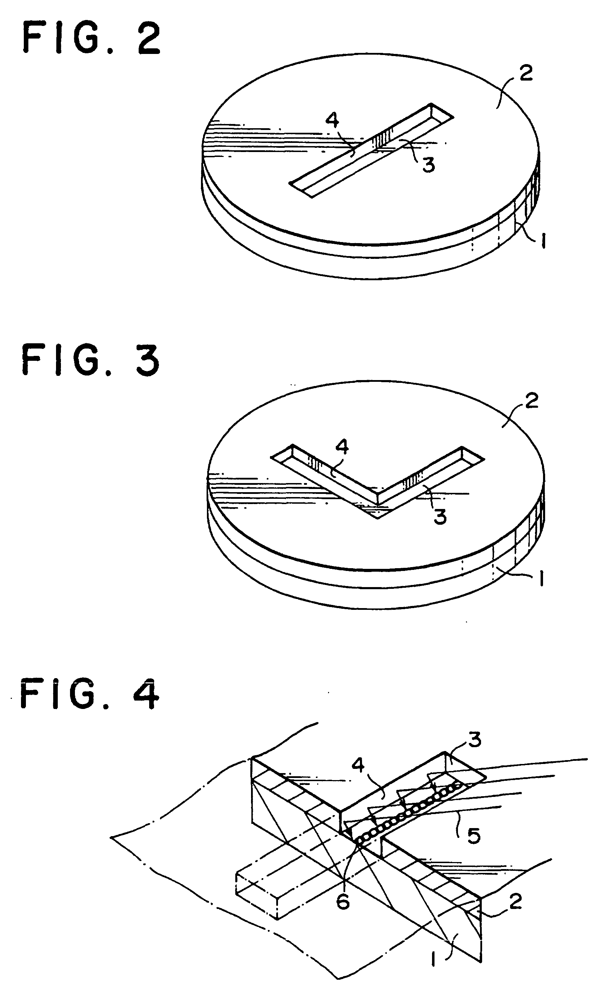

As shown in Fig. 1A, a target material 2, which is a material for forming ultrafine particles, is disposed on the substrate 1. The target material 2, as shown in Fig. 2, is provided with a slit 3 corresponding to a shape of an ultrafine particle structure to be obtained. In other words, the target material 2 has a slit 3 corresponding to a continuously disposedshape of ultrafine particles. To an inner wall 4 of the slit 3, a high energy beam 5 is irradiated with an oblique direction from above as will be explained later, and thereby the ultrafine particles are formed by irradiating the high energy beam 5 in a slanting direction. Further, an ultrafine particle structure which is formed of a continuously disposed plurality of the ultrafine particles can be obtained.

A shape of slit 3 can be a linear shape as shown in Fig. 2. It is not limited to the linear shape, however, and, for example, can be a shape having bend as shown in Fig. 3. The slit 3 can have a further complicated shape. A film composed of a desired target material can be provided with a slit 3 through a chemical method or an electrochemical method such as an etching and other method, or a laser beam and the like. Further, a number of the target material 2 is not limited to 1 but a plurality of target materials can be used in combination.

As the target material, various solid materials such as various single metals such as Pt, Au, Cu, Al, and the like and alloys thereof, semiconductors such as Si and the like, various compounds such as metal oxides, metal chlorides, metal fluorides, metal borides and the like, can be used. The various conditions can be set considering liberation potential of constitutional atoms or constitutional molecules from the target material 2, wherein the liberation potential is almost determined by an impact resistance of the target material 2 to a high energy beam 5, that is, a binding energy of crystal of the target material 2.

The slit 3 of the target material 2 provides a position for forming ultrafine particle structure thereon. In addition, an inner wall 4 of the slit 3 works as a surface for supplying forming material of ultrafine particles, namely the constitutional atoms or constitutional molecules of the target material 2. Therefore, a shape of the slit 3 and thickness of the target material 2 are determined by taking into consideration both shapes of ultrafine particles to be formed and continuously disposed ultrafine particle structure, further incident angle θ of the high energy beam 5.

A width w of the slit 3 of a direction parallel to an irradiation direction of a high energy beam 5 is preferable to be in the range of from 0.1 µm to 100 µm. Thickness of the target material 2 is preferable to be from 0.1 µm to 100 µm. If the width of the slit 3 is too narrow or the thickness of the target material 2 is too thin, an incident angle e of the high energy beam 5 is restricted, thereby formation of ultrafine particles, accordingly formation of the ultrafine particle structure can be made difficult. On the contrary, if the width of the slit is too large or the thickness of the target material 2 is too thick, the ultrafine particles, moreover, the ultrafine particle structure can be obtained with difficulty.

Further, a width w of the slit 3 and a thickness t of the target material 2 exert an influence on an incidence angle θ of a high energy beam 5. In order to obtain an ultrafine particle structure composed of ultrafine particles having diameter of from 2 to 200 µm, the incident angle θ of the high energy beam 5 is preferable to be set in the range of from 15 to 60 degrees. Accordingly, the width w of the slit 3 and the thickness t of the target material 2 are preferable to be set for tan⁻¹ (t/w) to be in the range of from 15 to 60 degrees. More preferably, for tan⁻¹ (t/w) to be in the range of from 30 to 45 degrees, the width w of the slit 3 and the thickness t of the target material 2 are set.

To an inner wall 4 of the slit of the target material 2 described above, as shown in Fig. 1B and Fig. 4, a high energy beam 5 is irradiated obliquely from above. The slanting irradiation of the high energy beam 5 can be executed simultaneously (collectively) on whole of the inner wall 4 of the slit. Instead, a narrowly focused high energy beam 5 can be continuously irradiated along the inner wall 4 of the slit. Further, the high energy beam 5 can be intermittently irradiated along the shape of the slit 3. That is, until ultrafine particles 6 of desired particle diameter are formed on the substrate 1 in accordance with a certain position of the inner wall 4 of the slit, the irradiation of the high energy beam 5 in a slanting direction is executed. Then, after shifting irradiation position along a direction of a long side of the slit 3, an ion beam 5 is similarly irradiated onto the inner wall 4 of the slit 3. This irradiation operation is executed along the shape of the slit 3. Thus, the irradiation operation of the high energy beam 5 is implemented in various modes.

By irradiating obliquely a high energy beam 5 to the inner wall 4 of the slit 3, constituent atoms or constituent molecules of the target material are liberated (in figure, shown by a dotted line with an arrow). The liberated constituent atoms and constituent molecules are stuck on the substrate 1 to form the ultrafine particles 6. The high energy beam 5 to be irradiated is not restricted to a specific one. Any type of the high energy beam 5 can be used if it has enough energy to liberate the constituent atoms and constituent molecules from the target material 2. For example, an ion beam such as an Ar ion beam having an acceleration voltage of from 2 to 5 kV and a beam current of around from 0.1 to 1 mA, an electron beam, a laser beam, X-rays, γ-rays, a neutron beam, and the like which can provide same impact to the target material 2 as the ion beam does can be cited.

When an ion beam is used as a high energy beam 5, if a acceleration voltage and a beam current is too small, the constituent atoms and molecules can not be effectively liberated from the target material 2. On the contrary, if the acceleration voltage and the beam current is too large, only impairment of the target material 2 increases, and the constituent atoms and molecules can not be controlled with respect to its escapability. The situation is the same with an electron beam, a laser beam, X -rays, γ-rays, a neutron beam, and the like as a high energy beam 5. An atmosphere for irradiating the high energy beam 5 can be determined according to a beam to be used. For example, a vacuum atmosphere and an inert gas atmosphere such as Ar atmosphere and the like can be cited. When ultrafine particles are formed from compounds, an oxygen-containing atmosphere and a nitrogen atmosphere can be used.

Through continuing an irradiation of a high energy beam 5 in a slanting direction for a definite time interval, the constituent atoms and molecules of the target material 2 can be liberated continuously, thereby the ultrafine particles 6 are grown to desired shape. In this case, individual shapes of the ultrafine particles 6 are appropriately set according to a final shape of an ultrafine particle structure. To obtain an ultrafine particle structure of nanometer order meeting an objective of the present invention, it is preferable to set diameter of the ultrafine particles in the range of from 2 to 200 nm. Ultrafine particles having a diameter of less than 2 nm are difficult to form. On the contrary, if the diameters of the ultrafine particles 6 exceed 200 nm, an effect expected from ultrafine particle structure of nanometer order can be impaired. The diameter of the ultrafine particles 6 is preferable to be in the range of from 2 to 200 nm, and more preferable to be in the range of from 2 to 50 nm. An irradiation time interval of the high energy beam 5 is appropriately determined according to an intensity of the high energy beam 5 and a desired dimension of the ultrafine particles 6.

As shown in Fig. 1C, through simultaneous or continuous formation of the ultrafine particles 6 along whole length of the inner wall 4 of the slit, a plurality of ultrafine particles 6 are disposed along a shape of a long side of the slit 3. A plurality of the ultrafine particles 6 are disposed continuously forming a desired shape, and, by contacting or bonding the ultrafine particles, can constitute an ultrafine particle structure 7. Bonding state between neighboring ultrafine particles 6 can be partial. Interconnection between the neighboring ultrafine particles 6 can be simple contact, but it is preferable to be at least partially bonded.

When a high energy beam 5 is scanned in turn along an inner wall 4 of a slit, by controlling each irradiated positions of the high energy beam 5, a plurality of ultrafine particles 6 are disposed continuously forming a desired shape. Thus, an ultrafine particle structure 7 is formed from a plurality of the ultrafine particles disposed continuously forming a desired shape.

Further, in Fig. 1C, respective numbers of ultrafine particle 6 along both directions of width w of the slit 3 and of height t on the substrate 1 are one. By disposing continuously the ultrafine particles 6, an ultrafine particle structure 7 can be obtained. The ultrafine particle structure 7 of the present invention is not restricted to this one. While disposing a plurality of ultrafine particles 6 along directions of width w of the slit 3 and of height t, by continuously disposing these ultrafine particles 6 along a long side direction of the slit 3, the ultrafine particle structure can be formed.

During irradiation of a high energy beam 5, the substrate 1 can be kept at room temperature, or can be heated. The temperature of the substrate 1 exerts influence on crystalline state of the ultrafine particles 6 to be obtained. When the substrate 1 is kept at room temperature, the ultrafine particles 6 are liable to form a low crystalline or an amorphous state. When the substrate 1 is heated, the crystalline state of the ultrafine particles 6 can be controlled according to the temperature. The crystalline state of the ultrafine particles 6 are also controlled by heating or irradiating an electron beam on the substrate after formation of the ultrafine particles 6.

Here, an ultrafine particle structure 7 formed by irradiating a high energy beam 5 in a slanting direction is basically continuous, but bonding states between the neighboring ultrafine particles 6 can be less stable depending on formation conditions. In such a case, for example, as shown in Fig. 1D, for example an irradiation of an electron beam 8 on the whole of the ultrafine particle structure 7 is effective. By irradiating an electron beam 8, adjacent ultrafine particles 6 are more completely bonded, thereby an ultrafine particle structure 7' having a continuous pattern obtained by bonding between ultrafine particles 6 can be obtained. By bonding between the ultrafine particles 6 as described above, mechanical or electrical bonding state between the ultrafine particles can be greatly improved. An electron beam 8 to be used for bonding between the ultrafine particles is preferable to have an intensity of not less than 1 X 10¹⁹ e/cm²·sec. Such an electron beam 8 realizes stabilization of bonding state between the ultrafine particles 6. In a thus obtained ultrafine particle structure 7 (includes an ultrafine particle structure 7' which are bonded between ultrafine particles), a position to be formed on the substrate 1 can be corresponded to the slit 3 of the target material 2. Further, its minimum width can be controlled to the diameter of the ultrafine particles 6, for example, from 2 to 200 nm (further to order of from 2 to 100 nm). Still further, dimension of the ultrafine particles 6 can be controlled by a temperature of substrate 1, an intensity of a high energy beam 5, an irradiation time period, an irradiation atmosphere, a thickness of target material 2, and a width of slit 3. Corresponding to the shape of the ultrafine particle structure 7, various types of the ultrafine particles 6 can be obtained.

In the above embodiment, an explanation is given for the case where the target material 2 is one type. In the present invention, further, a plurality of target materials of the same substance and different slit shapes, a plurality of target materials of different substances, a plurality of target materials which are different both in substances and slit shapes can be used. In the present invention, a plurality of target materials having various configurations can be combined.

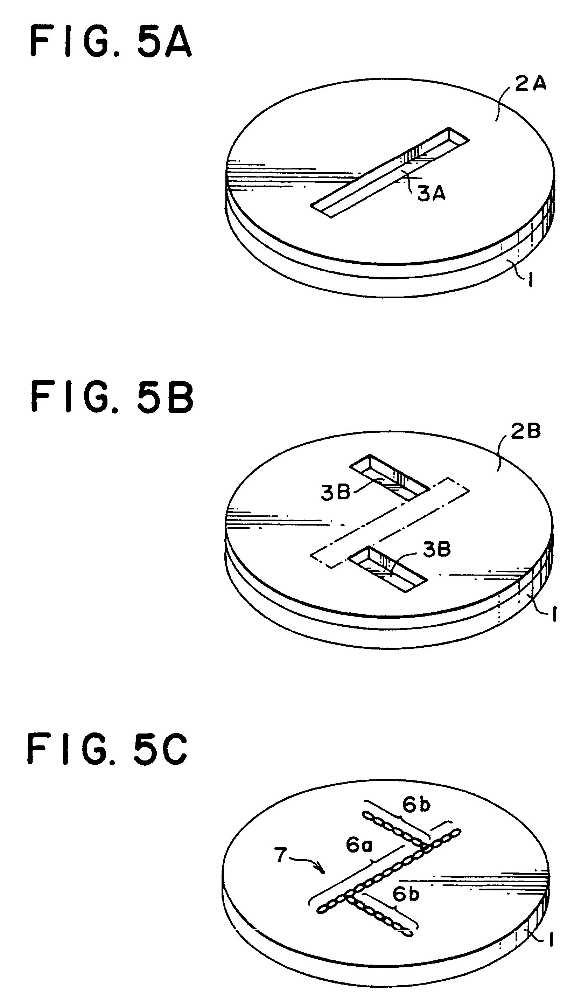

For example, as shown in Fig. 5A, firstly, a first target material 2a having a slit 3a of a first pattern is disposed on the substrate 1. By irradiating above described high energy beam in a slanting direction, the ultrafine particles are disposed continuously forming a first pattern. Then, as shown in Fig. 5B, the target material is replaced by a second target material 2b having a slit 3b of a second pattern. A high energy beam is irradiated in a slanting direction to the second target material 2b, thereby ultrafine particles are disposed continuously forming the second pattern.

As shown in Fig. 5C, by using a plurality of target materials 2a, 2b having respective slits 3a, 3b of different patterns, an ultrafine particle structure 7 composed of ultrafine particles 6a, which are disposed continuously according to the first pattern, and ultrafine particles 6b, which are disposed continuously according to the second pattern, can be obtained.

Thus, by employing a plurality of target materials having different slit shapes, an ultrafine particle structure 7 having a more complicated pattern can be produced. In this case, by changing substances for the target materials 2a, 2b, an ultrafine particle structure formed of a combination of ultrafine particles of different substances can be obtained. Further, if a plurality of target materials of same slit shape and different substances are used, an ultrafine particle structure composed of mixtures, compounds, alloys, and the like of a plurality of types of ultrafine particles of different substances can be obtained. Since the substance of the target material and the shape of the slit can be selected arbitrarily, an ultrafine particle bonded bodies having various configuration can be obtained.

In an ultrafine particle structure 7 formed in a desired shape through continuously disposing a plurality of ultrafine particles 6, whole shape can be controlled by slit 3, and, further, its width can be made nanometer order corresponding to diameter of the ultrafine particles 6. Therefore, an ultrafine wiring, an ultrafine device, an ultrafine functional material and the like of nanometer order dimension which utilize the ultrafine particles can be realized. Further, by controlling bonding state between the adjacent ultrafine particles 6, an ultrafine particle structure 7 retaining characteristics of the ultrafine particles 6 can be obtained.

For example, by applying an ultrafine particle structure 7 of about 10 nm width to an ultrafine wiring, a wiring having an integration level of from 5 to 10 G bit class can be realized. By using a plurality of target materials 2 of different substances, for example, by disposing in a combined manner ultrafine particles of conductive metal, semiconductor, and compound composed of insulating metal oxide or the like, an ultrafine particle structure 7 can be utilized as ultrafine electronic device such as ultrafine transistor, ultrafine diode, and ultrafine superconductive device. It can be applied also to ultrafine optical device and ultrafine magnetic device. Further, an ultrafine particle structure 7, through appropriately selecting a shape of the slit 3 and thereby discontinuously forming the ultrafine particles, can be applied as ultrafine electronic device and the like which utilize an tunnel effect between the ultrafine particles and a quantum mechanical effect (quantum well, mini-band, and the like).

Other than those described above, the ultrafine particle structure 7 of the present invention can be applied to various types of functional devices such as nonlinear optics materials, catalysts, biomedical materials, atomic filters, and the like. Further, when the ultrafine particle structure 7 of the present invention is applied to a various electronic devices and functional materials, since constituent material of the ultrafine particles and crystalline state can be controlled, study of applicability and expansion of applying field can be tried.

Now description will be made of specific embodiments of the present invention.

### [Embodiment 1]

In the process for producing the ultrafine particle structure shown in Fig. 1A to Fig. 1D, a carbon film was used as the substrate 1. An Al target material, which has thickness of 0.5 µm and the slit 3 of linear shape of 0.5 µm width, was disposed as the target material 2 on the carbon film. These materials were placed on a room temperature stage in a vacuum chamber.

An Ar ion beam was irradiated in a slanting direction along whole long length side of the inner wall of the slit of the Al target material for 180 second. The Ar beam had an acceleration voltage of 3.5 kV and a beam current of 0.5 mA. An incident angle θ of the Ar beam was 40 degrees. Ar ion beam was irradiated in a vacuum atmosphere (includes Ar) of about 1 X 10⁻³ Pa.

After irradiation of the Ar ion beam, the surface of the carbon film was subjected to TEM observation. It was found that, on the surface of the carbon film, a plurality of Al ultrafine particles of diameter of about 5 nm were continuously disposed corresponding to the shape of the slit.

A plurality of the Al ultrafine particles mentioned above were almost bonded between the adjacent Al ultrafine particles. An electron beam of intensity of 1 X 10²⁰e/cm²·sec was further irradiated on a thus obtained plurality of the Al ultrafine particles for 300 sec. As a result, it was confirmed that an adjacent plurality of Al ultrafine particles were bonded between them to form a continuous pattern.

Thus, by irradiating Ar ion beam in a slanting direction to the inner wall of the Al target material simultaneously along the shape of the slit, Al atoms (Al cluster) are liberated from the Al target material to form a plurality of Al ultrafine particles. Thus an obtained plurality of the Al ultrafine particles are disposed continuously along the shape of the slit. Consequently, an ultrafine particle structure, which is formed by disposing continuously the ultrafine particles in a desired shape, can be obtained. The Al ultrafine particle structure of the present embodiment can be used, for example, as an ultrafine wiring.

### [Embodiment 2]

Similarly as embodiment 1 except for changing target material to Si target of a similar slit, Ar ion beam was irradiated in a slanting direction. It was confirmed that a plurality of Si ultrafine particles are continuously disposed on the carbon film at the positions corresponding to the slit. Diameter of the Si ultrafine particles were about 8 nm.

As explained above, according to the present invention, ultrafine particle structure of various shapes and properties can be obtained by utilizing ultrafine particles. Thus, immense contribution to application and development of ultrafine wirings, ultrafine devices, ultrafine functional materials, and the like, which utilize the ultrafine particles, can be expected.

## Claims

1. An ultrafine particle structure comprising a substrate having a main surface and a plurality of ultrafine particles disposed continuously on the main surface of the substrate,
wherein the ultrafine particles are composed of constituent atoms or molecules detached from a target material, which has a slit and is disposed on the substrate, by irradiating a high energy beam in a slanting direction, and exist at a position corresponding to the slit.

2. An ultrafine particle structure according to claim 1,
wherein the ultrafine particles are at least partially bonded between adjacent ultrafine particles.

3. An ultrafine particle structure according to claim 1,
wherein the ultrafine particles are bonded between adjacent ultrafine particles by irradiation of an electron beam.

4. An ultrafine particle structure according to any one of claims 1 to 3,
wherein the ultrafine particles have diameters in the range from 2 to 200nm respectively.

5. An ultrafine particle structure according to any one of claims 1 to 4,
wherein the ultrafine particles are at least one selected from metal ultrafine particles, semiconductor ultrafine particles, and compound ultrafine particles.

6. An ultrafine particle structure according to claim 5,
wherein the ultrafine particles have a plurality of types of ultrafine particles of different substances.

7. An ultrafine particle structure according to any one of claims 1 to 6,
wherein the ultrafine particle structure is used as one member selected from an ultrafine electronic device, an ultrafine optical device, an ultrafine magnetic device, and an ultrafine functional material.

8. A method for producing an ultrafine particle structure, comprising:
disposing a target material having a slit of desired shape on a substrate;
irradiating a high energy beam collectively in a slanting direction on an inner wall surface of the slit of the target material to detach constituent atoms or molecules of the target material; and
forming a plurality of ultrafine particles by adhering the constituent atoms or molecules detached from the target material on the substrate, wherein the ultrafine particles are disposed on the substrate along the shape of the slit.

9. A method for producing an ultrafine particle structure, comprising:
disposing a target material having a slit of desired shape on a substrate;
irradiating a high energy beam continuously or intermittently in a slanting direction on an inner wall surface of the slit of the target material along the shape of the slit to detach constituent atoms or molecules of the target material; and
forming a plurality of ultrafine particles by adhering the constituent atoms or molecules detached from the target material on the substrate, wherein the ultrafine particles are disposed continuously on the substrate along the shape of the slit.

10. A method for producing an ultrafine particle structure according to claim 8 or 9,
wherein the ultrafine particles are at least one selected from metal ultrafine particles, semiconductor ultrafine particles, and compound ultrafine particles.

11. A method for producing an ultrafine particle structure according to any one of claims 8 to 10,
wherein the high energy beam is irradiated in a slanting direction to a plurality of the target materials different in at least one of the shape of the slit and substance.

12. A method for producing an ultrafine particle structure according to any one of claims 8 to 11,
wherein the high energy beam is an ion beam.

13. A method for producing an ultrafine particle structure according to any one of claims 8 to 12, further comprising:
irradiating an electron beam on the ultrafine particles to bond between adjacent ultrafine particles.

## Patentansprüche

1. Ultrafeine Partikelstruktur, welche ein Substrat mit einer Hauptfläche und mit einer großen Anzahl von ultrafeinen Partikeln umfasst, welche kontinuierlich auf der Hauptfläche des Substrats angeordnet sind,
wobei die ultrafeinen Partikel zusammengesetzt sind aus Komponentenatomen oder Komponentenmolekülen, welche von einem Zielmaterial, welches einen Schlitz aufweist und welches auf dem Substrat angeordnet ist, durch Einstrahlung eines Strahles mit einer hohen Energie in einer schrägen Richtung abgetrennt worden sind, und wobei die ultrafeinen Partikel an einer dem Schlitz entsprechenden Position vorhanden sind.

2. Ultrafeine Partikelstruktur gemäß Anspruch 1,
bei welcher die ultrafeinen Partikel mindestens teilweise zwischen benachbarten ultrafeinen Partikeln gebunden sind.

3. Ultrafeine Partikelstruktur gemäß Anspruch 1,
bei welcher die ultrafeinen Partikel zwischen benachbarten ultrafeinen Partikeln durch Bestrahlung mit einem Elektronenstrahl gebunden werden.

4. Ultrafeine Partikelstruktur gemäß irgendeinem der Ansprüche 1 bis 3,
bei welcher die ultrafeinen Partikel Durchmesser in dem Bereich von jeweils 2 bis 200 nm aufweisen.

5. Ultrafeine Partikelstruktur gemäß irgendeinem der Ansprüche 1 bis 4,
bei welcher von den ultrafeinen Partikeln mindestens eine ausgewählt wird unter ultrafeinen Partikeln von Metall, unter ultrafeinen Partikeln von Halbleitern und unter ultrafeinen kombinierten Partikeln.

6. Ultrafeine Partikelstruktur gemäß Anspruch 5,
bei welcher die ultrafeinen Partikel eine große Anzahl von Typen ultrafeiner Partikel aus unterschiedlichen Substanzen aufweisen.

7. Ultrafeine Partikelstruktur gemäß irgendeinem der Ansprüche 1 bis 6,
bei welcher die ultrafeine Partikelstruktur als ein Element verwendet wird, welches ausgewählt wird unter einer ultrafeinen elektronischen Vorrichtung, unter einer ultrafeinen optischen Vorrichtung, unter einer ultrafeinen magnetischen Vorrichtung und unter einem ultrafeinen funktionalen Material.

8. Verfahren zur Herstellung einer ultrafeinen Partikelstruktur, welches umfasst:
ein Auftragen eines Zielmaterials mit einem Schlitz einer gewünschten Form auf ein Substrat;
ein Bestrahlen mit einem hochenergetischen Strahl gemeinsam in einer schrägen Richtung auf eine innere Wandfläche des Schlitzes des Zielmaterials, um Komponentenatome oder -moleküle des Zielmaterials abzulösen; und
ein Bilden einer Vielzahl von ultrafeinen Partikeln durch ein Anhaften der Komponentenatome oder -moleküle, welche von dem Zielmaterial abgelöst worden sind, auf das Substrat, wobei die ultrafeinen Partikel auf dem Substrat entlang der Form des Schlitzes angeordnet werden.

9. Verfahren zur Herstellung einer ultrafeinen Partikelstruktur, welches umfasst:
ein Auftragen eines Zielmaterials mit einem Schlitz von einer gewünschten Form auf ein Substrat;
ein Bestrahlen mit einem hochenergetischen Strahl kontinuierlich oder intermittierend in einer schrägen Richtung auf eine innere Wandfläche des Schlitzes des Zielmaterials, entlang der Form des Schlitzes, um Komponentenatome oder -moleküle des Zielmaterials loszulösen; und
ein Bilden einer Vielzahl von ultrafeinen Partikeln durch ein Anhaften der Komponentenatome oder -moleküle, welche von dem Zielmaterial abgelöst worden sind, auf das Substrat, wobei die ultrafeinen Partikel auf dem Substrat entlang der Form des Schlitzes kontinuierlich angeordnet werden.

10. Verfahren zur Herstellung einer ultrafeinen Partikelstruktur gemäß den Ansprüchen 8 oder 9,
bei welchem von den ultrafeinen Partikeln mindestens eine ausgewählt wird unter ultrafeinen Partikeln von Metall, unter ultrafeinen Partikeln von Halbleitern und unter ultrafeinen kombinierten Partikeln.

11. Verfahren zur Herstellung einer ultrafeinen Partikelstruktur gemäß irgendeinem der Ansprüche 8 bis 10,
bei welchem der hochenergetische Strahl in einer schrägen Richtung auf eine große Anzahl der Zielmaterialien eingestrahlt wird, welche verschieden sind mindestens einem Merkmal unter der Form des Schlitzes und unter der Substanz.

12. Verfahren zur Herstellung einer ultrafeinen Partikelstruktur gemäß irgendeinem der Ansprüche 8 bis 11,
bei welchem der hochenergetische Strahl ein Ionenstrahl ist.

13. Verfahren zur Herstellung einer ultrafeinen Partikelstruktur gemäß irgendeinem der Ansprüche 8 bis 12, welches weiterhin umfasst:
ein Bestrahlen mit einem Elektronenstrahl auf die ultrafeinen Partikel, um eine Bindung zwischen benachbarten ultrafeinen Partikeln zu bewerkstelligen.

## Revendications

1. Structure de particules ultrafines comprenant un substrat possédant une surface principale et une pluralité de particules ultrafines déposées en continu sur la surface principale du substrat,
dans laquelle les particules ultrafines sont composées d'atomes ou de molécules constituants détachés d'un matériau cible, qui présente une fente et qui est déposé sur le substrat, par une irradiation d'un faisceau haute énergie dans une direction oblique, et existent à une position correspondant à la fente.

2. Structure de particules ultrafines suivant la revendication 1,
dans laquelle les particules ultrafines sont au moins partiellement liées entre particules ultrafines adjacentes.

3. Structure de particules ultrafines suivant la revendication 1,
dans laquelle les particules ultrafines sont liées entre particules ultrafines adjacentes par une irradiation d'un faisceau électronique.

4. Structure de particules ultrafines suivant l'une quelconque des revendications 1 à 3,
dans laquelle les particules ultrafines possèdent des diamètres dans l'intervalle de 2 à 200 nm respectivement.

5. Structure de particules ultrafines suivant l'une quelconque des revendications 1 à 4,
dans laquelle les particules ultrafines sont au moins un type choisi parmi des particules ultrafines métalliques, des particules ultrafines semi-conductrices et des particules ultrafines de composés.

6. Structure de particules ultrafines suivant la revendication 5,
dans laquelle les particules ultrafines possèdent une pluralité de types de particules ultrafines de différentes substances.

7. Structure de particules ultrafines suivant l'une quelconque des revendications 1 à 6,
dans laquelle la structure de particules ultrafines est utilisée en tant qu'un élément choisi parmi un dispositif électronique ultrafin, un dispositif optique ultrafin, un dispositif magnétique ultrafin et un matériau fonctionnel ultrafin.

8. Procédé pour la production d'une structure de particules ultrafines, comprenant:
le dépôt d'un matériau cible présentant une fente d'une forme désirée sur un substrat;
l'irradiation d'un faisceau haute énergie collectivement dans une direction oblique sur une surface de paroi interne de la fente du matériau cible pour détacher des atomes ou des molécules constituants du matériau cible; et
la formation d'une pluralité de particules ultrafines en faisant adhérer les atomes ou les molécules constituants détachés du matériau cible sur le substrat, où les particules ultrafines sont déposées sur le substrat le long de la forme de la fente.

9. Procédé pour la production d'une structure de particules ultrafines, comprenant:
le dépôt d'un matériau cible présentant une fente d'une forme désirée sur un substrat;
l'irradiation d'un faisceau haute énergie en continu ou par intermittence dans une direction oblique sur une surface de paroi interne de la fente du matériau cible le long de la forme de la fente pour détacher des atomes ou des molécules constituants du matériau cible; et
la formation d'une pluralité de particules ultrafines en faisant adhérer les atomes ou les molécules constituants détachés du matériau cible sur le substrat, où les particules ultrafines sont déposées en continu sur le substrat le long de la forme de la fente.

10. Procédé pour la production d'une structure de particules ultrafines suivant la revendication 8 ou 9,
dans lequel les particules ultrafines sont au moins un type choisi parmi des particules ultrafines métalliques, des particules ultrafines semi-conductrices et des particules ultrafines de composés.

11. Procédé pour la production d'une structure de particules ultrafines suivant l'une quelconque des revendications 8 à 10,
dans lequel le faisceau haute énergie est irradié dans une direction oblique sur une pluralité de matériaux cibles différents dans au moins une de la forme de la fente et de la substance.

12. Procédé pour la production d'une structure de particules ultrafines suivant l'une quelconque des revendications 8 à 11,
dans lequel le faisceau haute énergie est un faisceau ionique.

13. Procédé pour la production d'une structure de particules ultrafines suivant l'une quelconque des revendications 8 à 12, comprenant en outre:
l'irradiation d'un faisceau électronique sur les particules ultrafines pour une liaison entre particules ultrafines adjacentes.
